# FASCICULE DE BREVET EUROPEEN

(11) **EP 4 007 028 B1**
(45) Date de publication et mention de la délivrance du brevet: **24.04.2024**
(21) Numéro de dépôt: 21210805.4
(22) Date de dépôt: 26.11.2021
(51) Int. Cl.: H01M 10/052, G01N 1/22, G01N 33/00, H01M 10/0562, H01M 10/0565, H01M 10/42, G01R 31/364

(54) **CELLULE POUR TESTER UNE BATTERIE ELECTROCHIMIQUE TOUT SOLIDE AVEC MESURE SIMULTANEE DES GAZ GENERES**
ZELLE ZUM TESTEN EINER ELEKTROCHEMISCHEN FESTSTOFFBATTERIE MIT GLEICHZEITIGER MESSUNG DER ERZEUGTEN GASE
CELL FOR TESTING AN ALL-SOLID STATE ELECTROCHEMICAL BATTERY WITH SIMULTANEOUS MEASUREMENT OF THE GENERATED GASES

(30) Priorité: 30.11.2020 FR 2012426
(43) Date de publication de la demande: 01.06.2022
(73) Titulaire: Commissariat à l'Energie Atomique et aux Energies Alternatives, 75015 Paris (FR)
(72) Inventeur: PROFATILOVA, Irina, 38054 GRENOBLE Cedex 09 (FR); GAILLARD, Frédéric, 38054 GRENOBLE Cedex 09 (FR); TARNOPOLSKIY, Vasily, 38054 GRENOBLE Cedex 09 (FR)
(74) Mandataire: Atout PI Laplace

(56) Documents cités:
- EP-A1- 3 300 159

## Description

L'invention se situe dans le domaine technique de test de batteries, et plus spécifiquement des batteries Lithium-ion à électrolytes solides ou polymères. L'invention concerne une cellule pour tester une batterie à pression constante et à températures élevées avec mesure simultanée des gaz générés pendant un cycle.

Compte tenu de la croissance rapide et énorme du marché des batteries de véhicules électriques au cours des dernières années, il existe un grand intérêt pour les batteries tout solides en raison de leurs propriétés de sécurité potentiellement améliorées.

La production de gaz est l'un des événements ayant un impact direct sur la sécurité des batteries lithium-ion. Cependant, la recherche et le développement de matériaux de batteries entièrement solides sont toujours en cours et des recherches sur leurs propriétés de génération de gaz sont nécessaires dans chaque cas.

La génération de gaz pendant un cycle électrochimique en lien avec les réactions électrochimiques est problématique. Les gaz générés peuvent endommager les contacts électriques de la batterie, augmenter la pression dans la batterie, puis la fuite de gaz toxiques ou explosion.

Les gaz H2S, SO2, O2 sont connus pour évoluer dans les batteries Li-ion contenant des cathodes d'oxyde en couches, des électrolytes à l'état solide à base de sulfures et du LLZO (abréviation de Lithium Lanthanum Zirconate Garnet). Ce phénomène présente un grand intérêt pour comprendre les voies de dégradation des batteries et les risques pour la sécurité. En conséquence, il y a un grand intérêt scientifique et pratique à observer ces gaz en mode operando pendant le fonctionnement d'une vraie batterie à électrolytes solides.

Actuellement, aucune cellule commerciale n'est disponible pour pouvoir effectuer des tests électrochimiques polyvalents de batteries entièrement solides couplés à des mesures opérationnelles des gaz dégagés.

Il existe un besoin d'une cellule électrochimique avec laquelle il est possible d'effectuer un cycle électrochimique représentatif d'une batterie solide. En outre, une telle cellule doit présenter une compatibilité chimique avec les produits de dégradation cellulaire en mode operando. En effet, il est connu que certains gaz peuvent être adsorbés sur la plupart des surfaces métalliques. De plus, des gaz tels que H2S et SO2 sont corrosifs en présence de traces d'humidité. Par conséquent, afin de ne pas perdre par adsorption et sous-estimer les gaz formés à l'intérieur de la cellule et pour maintenir un bon contact électrique, une protection des surfaces est nécessaire en gardant à l'esprit la conductivité électronique des contacts électriques. EP 3300159 divulgue un dispositif de test de cellule électrochimique, comprenant une base comprenant au moins un compartiment de test, un premier et un second collecteur de courant disposés à l'intérieur du compartiment de test de sorte que les collecteurs de courant se font face, au moins une sonde de mesure disposée à l'intérieur du compartiment de test, des connecteurs électriques pour les collecteurs de courant et la au moins une sonde de mesure, dans lequel les connecteurs électriques sont agencés accessibles depuis l'extérieur du compartiment de test, et un couvercle fermant hermétiquement le au moins un compartiment de test. Le compartiment de test est adapté pour recevoir des électrodes et un électrolyte d'une cellule électrochimique à tester.

L'invention vise à pallier tout ou partie des problèmes cités plus haut en proposant un nouveau concept de cellule électrochimique pour tester une batterie à pression constante et à températures élevées avec mesure simultanée des gaz générés pendant un cycle. La cellule électrochimique proposée permet d'effectuer un cycle électrochimique représentatif d'une batterie solide tout en garantissant une compatibilité chimique avec les produits de dégradation cellulaire en mode operando.

La solution de l'invention propose une cellule avec des connexions électriques résistantes à l'atmosphère agressive due aux gaz générés et formant en outre à la fois un accès aux gaz générés pour leur mesure et un environnement étanche aux gaz pour les autres éléments de la cellule.

A cet effet, l'invention a pour objet une cellule pour tester une batterie électrochimique, comprenant deux électrodes, préférentiellement en carbone vitreux, destinées à être en contact électrique avec la batterie à tester.

Dans un mode de réalisation, la cellule selon l'invention comprend:
a. une cellule de test en céramique non-conductrice ou en polyétheréthercétone (PEEK), préférentiellement en polyétheréthercétone (PEEK), comprenant :
   i. Une cavité destinée à recevoir la batterie à tester, la batterie étant destinée à être soumise à un cycle électrochimique;
   ii. Un orifice de sortie de gaz généré pendant le cycle électrochimique, l'orifice de sortie étant en connexion fluidique avec la cavité et de section sensiblement perpendiculaire à un premier axe ;
b. un dispositif d'application d'une température et d'une pression à la batterie, comprenant les deux électrodes, le dispositif étant étanche aux gaz générés par la batterie pendant le cycle électrochimique
c. la cellule de test comprend une ouverture traversante s'étendant selon un deuxième axe, sécant avec le premier axe, préférentiellement perpendiculaire, incluant la cavité, et
d. le dispositif d'application comprend une partie métallique inférieure et une partie métallique supérieure, chacune comprenant une protubérance s'étendant selon le deuxième axe dans l'ouverture traversante et de forme complémentaire à l'ouverture traversante, chaque protubérance se terminant par une des deux électrodes, préférentiellement fixée à ladite protubérance par une colle conductrice ;
la partie inférieure et la partie supérieure étant mobile en translation selon le deuxième axe l'une par rapport à l'autre, de sorte à appliquer la pression à la batterie.

Dans un autre mode de réalisation, la cellule de test comprend un orifice d'entrée, situé à l'opposé de l'orifice de sortie par rapport à la cavité le long du premier axe, d'un gaz porteur en connexion fluidique avec la cavité.

Avantageusement, la cellule comprend en outre un collecteur destiné à récupérer à l'orifice de sortie de gaz les gaz provenant de la cavité pendant le cycle électrochimique.

Avantageusement, le dispositif d'application comprend une presse chauffante comprenant une plaque supérieure et une plaque inférieure métalliques mobiles en translation l'une par rapport à l'autre selon le deuxième axe, la plaque supérieure étant disposée au-dessus de la partie supérieure, la plaque inférieure étant disposée en-dessous de la partie inférieure, de sorte à appliquer la température à la batterie.

Avantageusement, le dispositif d'application comprend un élément présentant un degré de liberté en translation selon un deuxième axe sécant avec le premier axe, préférentiellement perpendiculaire.

Avantageusement, la cellule de test comprend une première vis creuse filetée positionnée dans l'orifice d'entrée de gaz porteur, et destinée à relier la cavité à un dispositif d'alimentation en gaz porteur, la première vis creuse filetée étant préférentiellement en PEEK, et encore préférentiellement recouverte de PTFE.

Avantageusement, la cellule de test comprend une deuxième vis creuse filetée positionnée dans l'orifice de sortie de gaz et reliant la cavité au collecteur, la deuxième vis creuse filetée étant préférentiellement en PEEK, et encore préférentiellement recouverte de PTFE.

L'invention concerne aussi un procédé de test d'une batterie électrochimique dans une cellule comprenant les étapes suivantes
a. Fourniture d'une batterie à tester;
b. Prise d'un contact électrique avec la batterie à tester par deux électrodes, préférentiellement en carbone vitreux, de la cellule
c. Soumission de la batterie à un cycle électrochimique.

Avantageusement, l'étape de soumission de la batterie à un cycle électrochimique comprend simultanément une étape d'application d'une pression et d'une température à la batterie et une étape de maintien de l'étanchéité du contact électrique aux gaz générés par la batterie pendant le cycle électrochimique.

L'invention sera mieux comprise et d'autres avantages apparaîtront à la lecture de la description détaillée d'un mode de réalisation donné à titre d'exemple, description illustrée par le dessin joint dans lequel :
la figure 1 représente schématiquement la prise de contact électrique entre une batterie à tester et une cellule selon l'invention
la figure 2 représente schématiquement un mode de réalisation d'une cellule selon l'invention;
la figure 3 représente schématiquement un dispositif d'application d'une pression à la batterie de la cellule selon l'invention
la figure 4 représente schématiquement un dispositif d'application d'une température à la batterie de la cellule selon l'invention
la figure 5 représente schématiquement un autre mode de réalisation de la cellule selon l'invention;
la figure 6 représente un organigramme illustrant les étapes d'un procédé de test d'une batterie dans une cellule selon l'invention

Sur ces figures, dans un souci de clarté, les échelles ne sont pas respectées. Par ailleurs, les mêmes éléments porteront les mêmes repères dans les différentes figures.

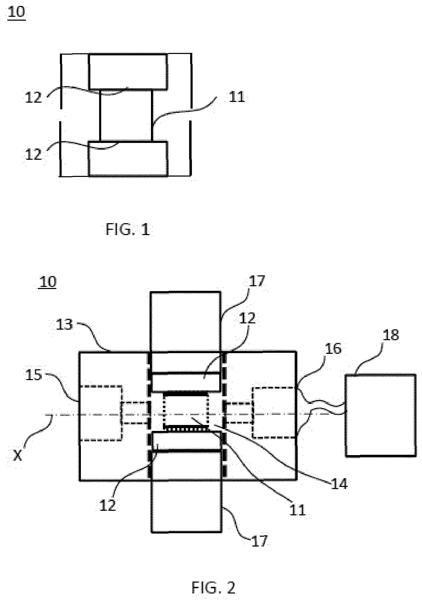

La figure 1 représente schématiquement la prise de contact électrique entre une batterie à tester 11 et une cellule 10 selon l'invention. La cellule 10 est destinée à tester une batterie 11. Selon l'invention, la cellule 10 comprend deux électrodes 12, préférentiellement en carbone vitreux, destinées à être en contact électrique avec la batterie 11 à tester. Les électrodes 12 peuvent alternativement être en carbure de tungstène, nickel, or ou platine. Les deux électrodes 12 permettent la prise de contact électrique de part et d'autre de la cellule 10 et donc de la batterie 11. Elles sont résistantes à l'atmosphère polluée et agressive qui règne dans la cellule électrochimique lors d'un cycle électrochimique lors duquel différents gaz sont générés. Les deux électrodes 12 permettent d'assurer la prise de contact malgré ces gaz qui endommagent les contacts électriques usuels.

La figure 2 représente schématiquement un mode de réalisation d'une cellule 10 selon l'invention. La cellule 10 comprend une cellule de test 13 en céramique non-conductrice, par exemple en alumine Al2O3, ou en polyétheréthercétone (PEEK ) et préférentiellement en PEEK, comprenant une cavité 14 destinée à recevoir la batterie 11 à tester, la batterie 11 étant destinée à être soumise à un cycle électrochimique. La cellule de test 13 comprend un orifice de sortie 16 de gaz généré pendant le cycle électrochimique. L'orifice de sortie 16 est en connexion fluidique avec la cavité 14 et est de section sensiblement perpendiculaire à un premier axe X. Enfin, la cellule électrochimique 10 comprend un dispositif d'application 17 d'une température et d'une pression à la batterie 11. Ce dispositif 17 comprend les deux électrodes 12, le dispositif 17 étant étanche aux gaz générés par la batterie 11 pendant le cycle électrochimique. Dans ce mode de réalisation, la cellule est configurée pour opérer sans gaz porteur. Le test est alors réalisé sous vide ou à une certaine pression. Le gaz généré lors du cycle électrochimique sort par l'orifice de sortie 16.

Dans un autre mode de réalisation (représenté sur la figure 2), la cellule de test 13 comprend un orifice d'entrée 15, situé à l'opposé de l'orifice de sortie 16 par rapport à la cavité 14 le long du premier axe X, d'un gaz porteur en connexion fluidique avec la cavité 14.

Grâce à la cellule de test et le dispositif d'application d'une température et d'une pression, la cellule présente une capacité à effectuer les tests de batteries entièrement solides sous pression réglable constante et température élevée, typiquement de l'ordre de 20 à 140 °C. Si la température de fonctionnement de batterie est différente, il est toutefois possible d'adapter cette température en fonction des matériaux utilisés. La pression constante est de l'ordre d'une tonne, mais si les matériaux utilisés ne sont pas trop durs, cette pression peut être inférieure, de l'ordre de 100 kg.

Le thermoplastique PEEK (polyetheretherketone) est généralement considéré comme l'un des plus performants dans le monde. Le PEEK offre des performances exceptionnelles dans une vaste plage de températures et de conditions extrêmes. Le PEEK combine des propriétés thermiques uniques avec des propriétés mécaniques et une résistance chimique. Ce matériau peut résister à une température de travail constante de 250°C et possède une excellente résistance chimique à long terme. En outre, il présente une excellente résistance chimique et mécanique, avec une garantie de rigidité et dureté à des températures élevées.

La cellule électrochimique 10 comprend en outre un collecteur 18 destiné à récupérer à l'orifice de sortie 16 de gaz les gaz provenant de la cavité 14 pendant le cycle électrochimique. Les gaz récupérés dans le collecteur 18 peuvent ensuite être analysés. Se trouveront dans le collecteur 18 le gaz porteur introduit dans la cellule et les gaz générés en lien avec les réactions électrochimiques et que l'on souhaite identifier et quantifier. Il est alors possible de mesurer le dégagement gazeux de la batterie en test. Cette cellule permet aussi réaliser le cyclage et l'analyse de gaz sans gaz porteur, y compris sous vide.

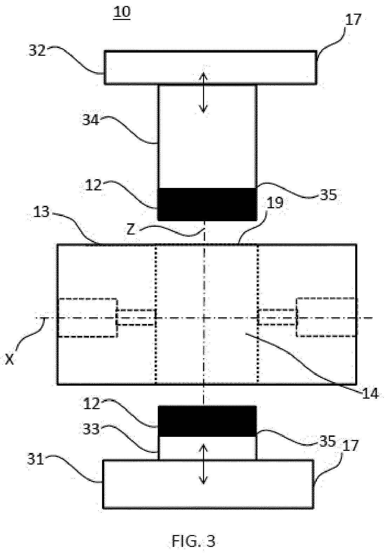

La figure 3 représente schématiquement un dispositif d'application 17 d'une pression à la batterie de la cellule électrochimique selon l'invention. Dans ce mode de réalisation, la cellule de test 13 comprend une ouverture traversante 19 s'étendant selon un deuxième axe Z, sécant avec le premier axe X, préférentiellement perpendiculaire, incluant la cavité 14. Et le dispositif 17 comprend une partie métallique inférieure 31 et une partie métallique supérieure 32, chacune comprenant une protubérance 33, 34 s'étendant selon le deuxième axe Z dans l'ouverture traversante 19 et de forme complémentaire à l'ouverture traversante 19, chaque protubérance 33, 34 se terminant par une des deux électrodes 12, préférentiellement fixée à ladite protubérance 33, 34 par une colle conductrice 35. La partie inférieure 31 et la partie supérieure 32 sont mobiles en translation selon le deuxième axe Z l'une par rapport à l'autre, de sorte à appliquer la pression à la batterie 11. Autrement dit, les protubérances 33, 34 vient appuyer de part et d'autre de la batterie 11 pour assurer le contact mécanique visant à exercer la pression prédéfinie pour le test, tout en assurant la prise de contact électrique par le biais des deux électrodes qui sont positionnées à l'extrémité des protubérances. On peut noter que sur la figure 3, chaque protubérance est mobile selon le deuxième axe Z. Toutefois, l'invention s'applique aussi au cas où l'une des protubérances, par exemple la protubérance inférieure 33, est fixe et en position dans la cellule de test, et seule l'autre protubérance, par exemple la protubérance supérieure 34, est mobile selon le deuxième axe.

Les parties métalliques 31, 32 peuvent être en n'importe quel métal qui résiste à la pression. Parmi eux, nous pouvons citer à titre d'exemple le carbure de tungstène ou l'acier inoxydable.

Avantageusement, la surface intérieure de l'ouverture 19 est lisse pour faciliter le mouvement de la protubérance à l'intérieur de l'ouverture et pour minimiser l'adsorption des gaz.

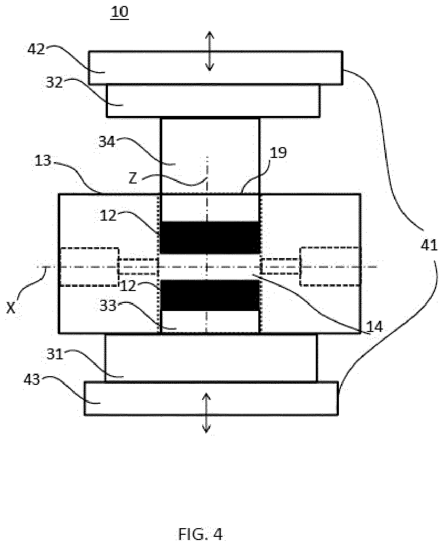

La figure 4 représente schématiquement un dispositif d'application 17 d'une température à la batterie de la cellule selon l'invention. Dans ce mode de réalisation, le dispositif 17 comprend une presse chauffante 41 comprenant une plaque supérieure 42 et une plaque inférieure 43 métalliques mobiles en translation l'une par rapport à l'autre selon le deuxième axe Z, la plaque supérieure 42 étant disposée au-dessus de la partie supérieure 32, la plaque inférieure 43 étant disposée en-dessous de la partie inférieure 31, de sorte à appliquer la température à la batterie 11. En chauffant ses plaques 42, 43, la presse chauffante 41 assure la montée en température des parties métalliques 32, 31 pour appliquer la gamme de température prédéfinie pour le cycle électrochimique à faire subir à la batterie à tester. En appliquant une pression sur les parties métalliques 32, 31, la presse chauffante 41 assure également l'application de la pression prédéfinie pour le cycle électrochimique à faire subir à la batterie à tester.

On peut noter que la presse chauffante 41 est un mode de réalisation privilégié pour l'application de la pression et de la température à la batterie. Toutefois, l'invention s'applique avec d'autres moyens chauffants des parties 31, 32, par exemple en utilisant une résistance électrique ou tout autre moyen de chauffage adapté connu d'un Homme du métier.

L'ensemble formé par la cellule de test et le dispositif d'application de pression et de température permet l'obtention d'un environnement étanche aux gaz dans la constitution de la cellule en elle-même, tout en appliquant la pression et les températures désirées. D'une part, la batterie à tester est soumise à un cycle électrochimique à la bonne pression et aux bonnes températures. Et d'autre part, la cellule selon l'invention demeure étanche aux gaz agressifs générés pendant le cycle, tout en permettant de garantir la prise de contact électrique par les électrodes 12 qui ne se détériorent pas. En outre, la cellule selon l'invention permet de capturer les gaz générés pendant le cycle pour une analyse ultérieure.

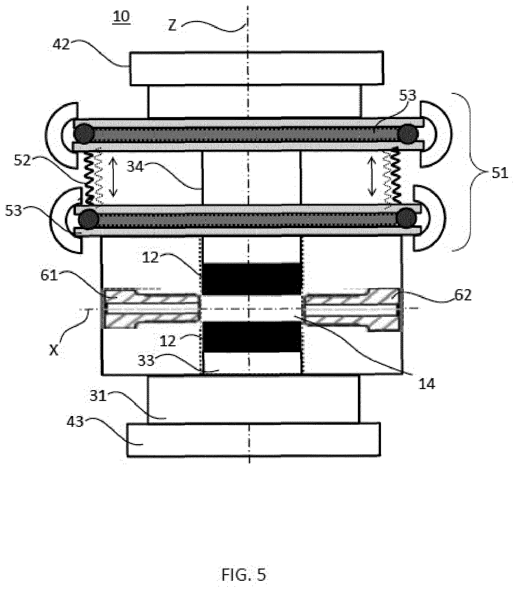

La figure 5 représente schématiquement un autre mode de réalisation de la cellule selon l'invention. Dans ce mode de réalisation, le dispositif 17 comprend un élément 51 présentant un degré de liberté en translation selon un deuxième axe Z sécant avec le premier axe X, préférentiellement perpendiculaire. L'élément 51 permet d'assurer l'étanchéité de montage pendant le cyclage, y compris sous vide et à chaud. L'élément 51 peut être un soufflet, un joint coulissant, un joint torique. Il en résulte une conception qui permet de rester étanche à l'air avec un piston en mouvement libre pendant les tests électrochimiques à long terme (généralement d'une durée de 1 à 30 jours): une conception spéciale d'une cellule de mesure comprenant un tuyau d'aspiration et des colliers.

Sur la figure 5, l'élément 51 de compensation est un soufflet 52. Il est positionné entre deux attaches 53 en contact avec la cellule de test d'une part et la partie supérieure 32 d'autre part. Les attaches 53 peuvent être en acier inoxydable ou en carbure de tungstène. Les joints dans 51 peuvent être en polymère. C'est un élastomère qui présente une très bonne résistance chimique aux autres fluides agressifs.

L'élément 51 peut se contracter et s'étendre pour compenser la dilatation des matériaux de la cellule. En outre, il permet d'ajuster la distance entre les deux électrodes 12 au moment de l'assemblage de la cellule.

Non représenté sur les figure, mais accessible à un Homme du métier, la cellule électrochimique comprend un joint autour de la protubérance 33 au niveau de la base de la cellule de test. Ce joint peut être par exemple en caoutchouc fluorocarbone (aussi connu sous l'appellation Viton^{®}).

Avantageusement, la cellule de test 13 comprend une première vis creuse filetée 61 positionnée dans l'orifice d'entrée 15 de gaz porteur, et destinée à relier la cavité à un dispositif d'alimentation en gaz porteur, et une deuxième vis creuse filetée 62 positionnée dans l'orifice de sortie 16 de gaz et reliant la cavité au collecteur. Les vis creuses permettent à l'écoulement gazeux du gaz porteur vers la cavité de la cellule de test et du gaz porteur avec les gaz générés par les réactions électrochimiques depuis la cavité vers le collecteur. Elles assurent la connexion mécanique avec le dispositif d'alimentation en gaz porteur et avec le collecteur. Préférentiellement, la première et/ou la deuxième vis creuse filetée 61, 62 sont en PEEK, et encore préférentiellement recouverte de PTFE pour assurer la fonction de joint. Ainsi les vis creuses sont résistantes chimiquement et mécaniquement, avec une garantie de tenue même à des températures élevées.

La cellule selon l'invention permet donc de maintenir un bon contact électrique, grâce aux électrodes, entre les protubérances qui agissent comme des pistons dans l'ouverture de la cellule de test et la batterie entièrement solide dans toutes les conditions de test possibles. Les contacts électriques réalisés par les électrodes chimiquement inertes assurent la conductivité électrique au sein de la cellule. Des collecteurs de courant en acier ou nickel peuvent être placés sur la batterie à tester.

Grâce à la conception de la cellule selon l'invention, la protection chimique des surfaces contre les gaz corrosifs est assurée. Les contacts électriques métalliques sont protégés par du carbone vitreux, du carbure de tungstène, nickel, or ou platine (selon les électrodes 12 utilisées) conducteur et inerte au niveau des électrodes. Les surfaces métalliques non conductrices sont avantageusement protégées par des solutions de passivation. Les parois intérieures de la cellule de test et les canaux conducteurs de gaz sont en polymère PEEK.

La cellule selon l'invention permet ainsi d'éviter les court-circuits en combinant des pièces métalliques et plastiques.

Le dispositif 17 d'application de la pression et de la température permet de contrôler à la fois la température de la batterie et la pression appliquée sur la batterie. Cette pression doit être constante. La flexibilité de l'élément 51 selon le deuxième axe permet d'absorber les variations de hauteur induites par la dilatation des matériaux soumis à de fortes températures.

La cellule de l'invention offre la capacité à effectuer un cycle électrochimique représentatif d'une batterie entièrement solide tout en étant compatible chimiquement de la cellule operando avec les produits de dégradation cellulaire. Cela est rendu possible par la fourniture des connexions électriques avec les électrodes. Comme expliqué précédemment, la cellule de test présente l'avantage de contrôler la pression et la température appliquées à la batterie de test. La température peut être réglée et/ou vérifiée au moyen d'un thermocouple disposé à proximité de la batterie à tester. On peut également noter que la pression est maintenue constante, mais la valeur de la pression appliquée peut être réglée. Pendant les mesures, la cellule électrochimique reste étanche à l'air : de par sa construction, aucun air extérieur ne pénètre dans la cavité, même en présence de dilatation des pièces qui est compensée par l'élément 51. Seul le gaz porteur peut entrer dans la cavité. Il en ressort avec les gaz générés et l'ensemble de ces gaz est récolté en sortie. Les mesures sans gaz porteurs, y compris sous vide, sont aussi faisables. La cellule permet de fournir un échantillonnage continu des produits de dégradation gazeux corrosifs issu du cycle électrochimique.

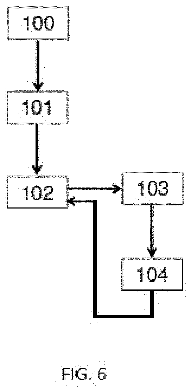

La figure 6 représente un organigramme illustrant les étapes d'un procédé de test d'une batterie 11 dans une cellule 10 selon l'invention. Le procédé de test d'une batterie 11 dans une cellule 10 comprend les étapes suivantes :
a. Fourniture d'une batterie 11 à tester (étape 100);
b. Prise d'un contact électrique avec la batterie 11 à tester (étape 101) par deux électrodes 12 de la cellule 10;
c. Soumission de la batterie 11 à un cycle électrochimique (étape 102).

Avantageusement, l'étape 102 de soumission de la batterie à un cycle électrochimique comprend simultanément une étape 103 d'application d'une pression et d'une température à la batterie 11 et une étape 104 de maintien de l'étanchéité du contact électrique aux gaz générés par la batterie 11 pendant le cycle électrochimique grâce à l'élément 51 qui présente un degré de liberté, comme expliqué précédemment. Le maintien de l'étanchéité du contact électrique est permis par la combinaison des protubérances 33, 34 qui viennent mettre en contact les électrodes 12 sur la batterie à tester 11 et l'application de pression par le dispositif 17.

## Revendications

1. Cellule (10) pour tester une batterie (11) électrochimique, **caractérisée en ce que** la cellule (10) comprend deux électrodes (12) préférentiellement en carbone vitreux, destinées à être en contact électrique avec la batterie (11) à tester ;
la cellule (10) comprenant :
a. une cellule de test (13) en céramique non-conductrice ou en polyétheréthercétone, comprenant :
i. Une cavité (14) destinée à recevoir la batterie (11) à tester, la batterie (11) étant destinée à être soumise à un cycle électrochimique;
ii. Un orifice de sortie (16) de gaz généré pendant le cycle électrochimique, l'orifice de sortie (16) étant en connexion fluidique avec la cavité (14)et de section sensiblement perpendiculaire à un premier axe (X) ;
b. un dispositif d'application (17) d'une température et d'une pression à la batterie (11), comprenant les deux électrodes (12), le dispositif (17) étant étanche aux gaz générés par la batterie (11) pendant le cycle électrochimique, les électrodes étant en matériau résistant à la corrosion ;
dans laquelle :
c. la cellule de test (13) comprend une ouverture traversante (19) s'étendant selon un deuxième axe (Z), sécant avec le premier axe (X), préférentiellement perpendiculaire, incluant la cavité (14), et
d. le dispositif d'application (17) comprend une partie métallique inférieure (31) et une partie métallique supérieure (32), chacune comprenant une protubérance (33, 34) s'étendant selon le deuxième axe (Z) dans l'ouverture traversante (19) et de forme complémentaire à l'ouverture traversante (19), chaque protubérance (33, 34) se terminant par une des deux électrodes (12), préférentiellement fixée à ladite protubérance (33, 34) par une colle conductrice (35) ;
la partie inférieure (31) et la partie supérieure (32) étant mobile en translation selon le deuxième axe (Z) l'une par rapport à l'autre, de sorte à appliquer la pression à la batterie (11).

2. Cellule (10) selon la revendication 1, dans laquelle la cellule de test (13) comprend un orifice d'entrée (15), situé à l'opposé de l'orifice de sortie (16) par rapport à la cavité (14) le long du premier axe (X), d'un gaz porteur en connexion fluidique avec la cavité (14).

3. Cellule (10) selon la revendication 1, comprenant en outre un collecteur (18) destiné à récupérer à l'orifice de sortie (16) de gaz les gaz provenant de la cavité (14) pendant le cycle électrochimique.

4. Cellule (10) selon l'une quelconque des revendications 1 à 3, dans laquelle le dispositif d'application (17) comprend une presse chauffante (41) comprenant une plaque supérieure (42) et une plaque inférieure (43) métalliques mobiles en translation l'une par rapport à l'autre selon le deuxième axe (Z), la plaque supérieure (42) étant disposée au-dessus de la partie supérieure (32), la plaque inférieure (43) étant disposée en-dessous de la partie inférieure (31), de sorte à appliquer la température à la batterie (11).

5. Cellule (10) selon l'une quelconque des revendications 1 à 4, dans laquelle le dispositif d'application (17) comprend un élément (51) présentant un degré de liberté en translation selon un deuxième axe (Z) sécant avec le premier axe (X), préférentiellement perpendiculaire.

6. Cellule (10) selon l'une quelconque des revendications 2 à 5, dans laquelle la cellule de test (13) comprend une première vis creuse filetée (61) positionnée dans l'orifice d'entrée (15) de gaz porteur, et destinée à relier la cavité à un dispositif d'alimentation en gaz porteur, la première vis creuse filetée (61) étant préférentiellement en polyétheréthercétone , et encore préférentiellement recouverte de PTFE.

7. Cellule (10) selon l'une quelconque des revendications 3 à 5, dans laquelle la cellule de test (13) comprend une deuxième vis creuse filetée (62) positionnée dans l'orifice de sortie (16) de gaz et reliant la cavité au collecteur (18), la deuxième vis creuse filetée (62) étant préférentiellement en polyétheréthercétone , et encore préférentiellement recouverte de PTFE.

8. Procédé de test d'une batterie (11) électrochimique dans une cellule (10) selon la revendication 1,
**caractérisé en ce qu'**il comprend les étapes suivantes :
a. Fourniture d'une batterie (11) à tester (étape 100);
b. Prise d'un contact électrique avec la batterie (11) à tester (étape 101) par deux électrodes (12), préférentiellement en carbone vitreux, de la cellule électrochimique (10) ;
c. Soumission de la batterie (11) à un cycle électrochimique (étape 102).

9. Procédé de test d'une batterie (11) électrochimique dans une cellule (10) selon la revendication 7, dans lequel l'étape (102) de soumission de la batterie à un cycle électrochimique comprend simultanément une étape (103) d'application d'une pression et d'une température à la batterie (11) et une étape (104) de maintien de l'étanchéité du contact électrique aux gaz générés par la batterie (11) pendant le cycle électrochimique.

## Patentansprüche

1. Zelle (10) zum Testen einer elektrochemischen Batterie (11), **dadurch gekennzeichnet, dass** die Zelle (10) zwei Elektroden (12) umfasst, die vorzugsweise aus glasartigem Kohlenstoff bestehen und dazu bestimmt sind, in elektrischem Kontakt mit der zu testenden Batterie (11) zu stehen;
wobei die Zelle (10) Folgendes umfasst:
a. eine Testzelle (13) aus nichtleitender Keramik oder Polyetheretherketon, Folgendes umfassend:
i. einen Hohlraum (14) zur Aufnahme der zu testenden Batterie (11), wobei die Batterie (11) dazu bestimmt ist, einem elektrochemischen Zyklus unterworfen zu werden;
ii. eine Austrittsöffnung (16) für das während des elektrochemischen Zyklus erzeugte Gas, wobei die Austrittsöffnung (16) in Fluidverbindung mit dem Hohlraum (14) steht und einen Querschnitt aufweist, der im Wesentlichen senkrecht zu einer ersten Achse (X) verläuft;
b. eine Vorrichtung (17) zum Anlegen einer Temperatur und eines Drucks an die Batterie (11), umfassend die beiden Elektroden (12), wobei die Vorrichtung (17) gegenüber den von der Batterie (11) während des elektrochemischen Zyklus erzeugten Gasen dicht ist, wobei die Elektroden aus korrosionsbeständigem Material bestehen;
wobei:
c. die Testzelle (13) eine Durchgangsöffnung (19) umfasst, die sich entlang einer zweiten Achse (Z) erstreckt, welche die erste Achse (X) schneidet, vorzugsweise senkrecht, und den Hohlraum (14) einschließt, und
d. die Applikationsvorrichtung (17) einen unteren metallischen Abschnitt (31) und einen oberen metallischen Abschnitt (32) umfasst, die jeweils einen Vorsprung (33, 34) umfassen, der sich entlang der zweiten Achse (Z) in der Durchgangsöffnung (19) erstreckt und eine zur Durchgangsöffnung (19) komplementäre Form aufweist, wobei jeder Vorsprung (33, 34) durch eine der beiden Elektroden (12) endet, die vorzugsweise durch einen leitfähigen Klebstoff (35) an dem Vorsprung (33, 34) befestigt ist;
wobei der untere Abschnitt (31) und der obere Abschnitt (32) entlang der zweiten Achse (Z) relativ zueinander translatorisch beweglich sind, so dass der Druck an die Batterie (11) angelegt wird.

2. Zelle (10) nach Anspruch 1, wobei die Testzelle (13) eine Einlassöffnung (15) umfasst, die gegenüber der Auslassöffnung (16) in Bezug auf den Hohlraum (14) entlang der ersten Achse (X) angeordnet ist, für ein Trägergas in Fluidverbindung mit dem Hohlraum (14).

3. Zelle (10) nach Anspruch 1, ferner umfassend einen Sammler (18), um an der Gasaustrittsöffnung (16) die aus dem Hohlraum (14) stammenden Gase während des elektrochemischen Zyklus zurückzugewinnen.

4. Zelle (10) nach einem der Ansprüche 1 bis 3, wobei die Applikationsvorrichtung (17) eine Heizpresse (41) umfasst, die eine obere Platte (42) und eine untere Platte (43) aus Metall umfasst, die entlang der zweiten Achse (Z) relativ zueinander translatorisch beweglich sind, wobei die obere Platte (42) über dem oberen Abschnitt (32) angeordnet ist und die untere Platte (43) unter dem unteren Abschnitt (31) angeordnet ist, um so die Temperatur an die Batterie (11) anzulegen.

5. Zelle (10) nach einem der Ansprüche 1 bis 4, wobei die Applikationsvorrichtung (17) ein Element (51) umfasst, das einen translatorischen Freiheitsgrad entlang einer zweiten Achse (Z) aufweist, welche die erste Achse (X) schneidet, vorzugsweise senkrecht.

6. Zelle (10) nach einem der Ansprüche 2 bis 5, wobei die Testzelle (13) eine erste hohle Gewindeschraube (61) umfasst, die in der Trägergaseinlassöffnung (15) positioniert ist und dazu dient, den Hohlraum mit einer Trägergaszuführvorrichtung zu verbinden, wobei die erste hohle Gewindeschraube (61) vorzugsweise aus Polyetheretherketon besteht und noch bevorzugter mit PTFE beschichtet ist.

7. Zelle (10) nach einem der Ansprüche 3 bis 5, wobei die Testzelle (13) eine zweite hohle Gewindeschraube (62) umfasst, die in der Gasaustrittsöffnung (16) positioniert ist und den Hohlraum mit dem Sammler (18) verbindet, wobei die zweite hohle Gewindeschraube (62) vorzugsweise aus Polyetheretherketon besteht und noch bevorzugter mit PTFE beschichtet ist.

8. Verfahren zum Testen einer elektrochemischen Batterie (11) in einer Zelle (10) nach Anspruch 1,
**dadurch gekennzeichnet, dass** es folgende Schritte umfasst:
a. Bereitstellen einer zu testenden Batterie (11) (Schritt 100);
b. Herstellen eines elektrischen Kontakts mit der zu testenden Batterie (11) (Schritt 101) durch zwei Elektroden (12), vorzugsweise aus glasartigem Kohlenstoff, der elektrochemischen Zelle (10);
c. Unterwerfen der Batterie (11) unter einen elektrochemischen Zyklus (Schritt 102).

9. Verfahren zum Testen einer elektrochemischen Batterie (11) in einer Zelle (10) nach Anspruch 7, wobei der Schritt (102), die Batterie einem elektrochemischen Zyklus zu unterwerfen, gleichzeitig einen Schritt (103) umfasst, bei dem ein Druck und eine Temperatur an die Batterie (11) angelegt werden, sowie einen Schritt (104), bei dem der elektrische Kontakt während des elektrochemischen Zyklus gegenüber den von der Batterie (11) erzeugten Gasen dicht gehalten wird.

## Claims

1. A cell (10) for testing an electrochemical battery (11), **characterised in that** the cell (10) comprises two electrodes (12), preferentially made of vitreous carbon, intended to be in electrical contact with the battery (11) to be tested;
the cell (10) comprising:
a. a test cell (13) made of non-conductive ceramic or of polyetheretherketone, comprising:
i. a cavity (14) intended to receive the battery (11) to be tested, the battery (11) being intended to be subjected to an electrochemical cycle;
ii. an outlet orifice (16) for gas generated during the electrochemical cycle, the outlet orifice (16) being fluidically connected with the cavity (14) and with a section substantially at right angles to a first axis (X);
b. a device (17) for applying a temperature and a pressure to the battery (11), comprising the two electrodes (12), the device (17) being tight to the gases generated by the battery (11) during the electrochemical cycle, the electrodes being made of a corrosion-resistant material;
wherein:
c. the test cell (13) comprises a through opening (19) extending along a second axis (Z), secant with the first axis (X), preferentially at right angles, including the cavity (14), and
d. the application device (17) comprises a bottom metal part (31) and a top metal part (32), each comprising a protuberance (33, 34) extending along the second axis (Z) in the through opening (19) and of complementary shape to the through opening (19), each protuberance (33, 34) being terminated by one of the two electrodes (12), preferentially fixed to said protuberance (33, 34) by a conductive glue (35);
the bottom part (31) and the top part (32) being movable in translation along the second axis (Z) relative to one another, so as to apply the pressure to the battery (11).

2. The cell (10) according to claim 1, wherein the test cell (13) comprises an inlet orifice (15), located opposite the outlet orifice (16) with respect to the cavity (14) along the first axis (X), for a carrier gas fluidically connected with the cavity (14).

3. The cell (10) according to claim 1, further comprising a collector (18) intended to recover, at the gas outlet orifice (16), the gases originating from the cavity (14) during the electrochemical cycle.

4. The cell (10) according to any one of claims 1 to 3, wherein the application device (17) comprises a heating press (41) comprising a metal top plate (42) and a metal bottom plate (43) that are movable in translation with respect to one another along the second axis (Z), the top plate (42) being disposed above the top part (32), the bottom plate (43) being disposed below the bottom part (31), so as to apply the temperature to the battery (11).

5. The cell (10) according to any one of claims 1 to 4, wherein the application device (17) comprises an element (51) having a degree of freedom in translation along a second axis (Z) secant with the first axis (X), preferentially at right angles.

6. The cell (10) according to any one of claims 2 to 5, wherein the test cell (13) comprises a first threaded hollow screw (61) positioned in the carrier gas inlet orifice (15), and intended to link the cavity to a carrier gas feed device, the first threaded hollow screw (61) being preferentially made of polyetheretherketone, and more preferentially covered with PTFE.

7. The cell (10) according to any one of claims 3 to 5, wherein the test cell (13) comprises a second threaded hollow screw (62) positioned in the gas outlet orifice (16) and linking the cavity to the collector (18), the second threaded hollow screw (62) being preferentially made of polyetheretherketone, and more preferentially covered with PTFE.

8. A method for testing an electrochemical battery (11) in a cell (10) according to claim 1,
**characterised in that** it comprises the following steps:
a. supplying a battery (11) to be tested (step 100);
b. making electrical contact with the battery (11) to be tested (step 101) via two electrodes (12), preferentially made of vitreous carbon, of the electrochemical cell (10);
c. subjecting the battery (11) to an electrochemical cycle (step 102).

9. The method for testing an electrochemical battery (11) in a cell (10) according to claim 7, wherein the step (102) of subjecting the battery to an electrochemical cycle simultaneously comprises a step (103) of applying a pressure and a temperature to the battery (11) and a step (104) of maintaining the tightness of the electrical contact to the gases generated by the battery (11) during the electrochemical cycle.
